Europäisches Patentamt

European Patent Office

Office européen des brevets

(11) Publication number: **0 224 644 B1**

(12) EUROPEAN PATENT SPECIFICATION

(45) Date of publication of patent specification: **01.04.92** (51) Int. Cl.⁵: **H03K 17/30**

(21) Application number: **86110252.3**

(22) Date of filing: **25.07.86**

(54) **Electronic trigger switch.**

(30) Priority: **26.11.85 US 801744**

(43) Date of publication of application:
**10.06.87 Bulletin  87/24**

(45) Publication of the grant of the patent:
**01.04.92 Bulletin  92/14**

(84) Designated Contracting States:
**BE CH DE FR GB IT LI SE**

(56) References cited:
**FR-A- 1 430 418**
**US-A- 4 338 546**

**FUNKSCHAU, vol. 38, no. 9, 1st May 1966,
page 270; "Einfache Schaltleistungsverstär-
kung"**

(73) Proprietor: **Teccor Electronics, Inc.
1801 Hurd Drive
Irving Texas 75062(US)**

(72) Inventor: **Little, Thomas Randal
2319 E. Mitchell
Arlington Texas 76010(US)**

(74) Representative: **UEXKÜLL & STOLBERG Paten-
tanwälte
Beselerstrasse 4
W-2000 Hamburg 52(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### TECHNICAL FIELD

This invention relates to electronic devices used to trigger thyristers, and in particular to the use of two silicon controlled rectifiers connected to function as a trigger switch for a TRIAC.

### BACKGROUND OF THE INVENTION

The thyristor family of semiconductor devices consists of several very useful devices, including silicon controlled rectifiers (SCRs), DIACS, and TRIACS. Thyristors are characterized by having two states, an on-state and an off-state, making them useful for electric power regulation, switching, and phase control.

An SCR is a unidirectional PNPN semiconductor device having an anode, a cathode, and a gate. In the off-state, an SCR is a high-resistance, low-current circuit element at voltages up to its breakover voltage. A momentary positive pulse applied to the gate of an SCR will bias the device so that it switches to the on-state and becomes a low-resistance, high-current element. Once an SCR is in the on-state, it will remain in the on-state until the principal anode to cathode current drops below the holding current of the device.

A TRIAC is a bidirectional thyristor which functions to control power in an AC electric circuit. The operation of a TRIAC can be related to two SCRs connected in inverse parallel. A TRIAC has a single gate, and the device can be triggered to the on-state by a gate pulse of either polarity. A TRIAC operates in a circuit in both directions essentially the same as an SCR behaves in its forward direction.

A DIAC is essentially an open base NPN transistor. A DIAC functions as a bidirectional circuit element which exhibits a high impedance state at voltages up to its voltage breakover point. Above the voltage breakover point a DIAC enters its on-state region, where current flows through the device as it exhibits decreasing resisitivity. Because of these characteristics, a DIAC can be used in a resistor-capacitor AC circuit to produce a bidirectional pulsing oscillator. In addition, a DIAC is an economical bidirectional device for triggering TRIACs in phase control circuits.

In many electrical applications it is desirable to have a power control circuit having a low voltage, low current triggering response with a relatively high holding current requirement. The high holding current can be provided by a TRIAC, but a standard DIAC does not provide the desired triggering characteristics for a TRIAC in such an application. This is because a standard DIAC has a higher voltage requirement and does not switch on completely at the breakover point. To achieve low voltage triggering capability for TRIACs, it has been necessary to construct relatively complicated triggering circuits comprising a plurality of transistors, resistors, and diodes in a bridge network. Such circuits have been simplified only to a limited extent by placing two integrated circuits on a chip to produce a silicon bilateral switch (SBS) such as the General Electric type 2N4991.

FUNKSCHAU, Vol.38, No.9, 1st May 1966, page 270, "Einfache Schaltleistungsvertärkung" discloses antiparallel connected SCR's controlling an AC-load, whose control gates are connected by a switch.

US-A-4 338 456 dicloses a switch including a TRIAC, controlled by twin sensitive-gate SCR's in antiparallel connection with the gates of the SCR's connected to a voltage divider circuit.

Because of the complexity of the prior art TRIAC triggering circuits, it is desirable to provide a simplified, economical, bidirectional, low voltage trigger device which switches on fully when the trigger voltage is reached.

### SUMMARY OF THE INVENTION

The invention relates to a low voltage bidirectional trigger switch for actuating a TRIAC having a TRIAC gate terminal and first and second main terminals, comprising:

(a) a first silicon controlled rectifier having gate, cathode and anode terminals;

(b) a second silicon controlled rectifier having gate, cathode and anode terminals;

(c) said first and second silicon controlled rectifiers being in antiparallel connection such that the anode of the first silicon controlled rectifier is connected to the TRIAC gate terminal and the cathode of the first silicon controlled rectifier is connected to the first main terminal, and the anode of the second silicon controlled rectifier is connected to the first main terminal and the cathode of the second silicon controlled rectifier is connected to the TRIAC gate terminal;

(d) said gate of the first silicon controlled rectifier being connected directly by an unswitched line to the gate of the second silicon controlled rectifier.

The introductory portion and features (a) - (c) of the independent Claim 1 are also known from the aforementioned US-A-4 338 456.

The present invention comprises a simplified electrical circuit which provides an economical, low voltage, bidirectional trigger switch for a TRIAC semiconductor device. The trigger switch of the present invention comprises two sensitive silicon controlled rectifiers (SCRs). A sensitive SCR has a very high gate impedance and can control anode currents in the 0.8 to 10 ampere range with gate trigger currents in the 12 to 500 microampere range.

The electronic trigger switch of the present invention is constructed by connecting two sensitive SCRs in inverse parallel relationship, such that the anode of one is connected to the cathode of the other and the gates are connected directly to each other, producing a device having only two main terminals. The sensitive SCRs connected in this manner provide a simple bidirectional trigger switch. When a positive potential is applied to one terminal of the trigger switch, the forward-biased SCR is initially in the off-state. When the voltage exceeds the peak inverse voltage (gate to cathode) of the reverse-biased SCR, the gate of the reverse-biased SCR provides a current to the gate of the forward-biased SCR to switch the forward-biased SCR to the on-state. With the forward-biased SCR switched to the on-state, current is able to pass through the trigger switch. Thus, it can be seen that the peak inverse voltage of the reversed-biased SCR corresponds to the breakover voltage of the trigger switch device. Furthermore, because of its opposite but symmetrical construction, the trigger switch functions as a bidirectional device.

The trigger switch of the present invention is particularly suited to function as a trigger for a TRIAC. The trigger switch is a bidirectional device, which is necessary for triggering a TRIAC, and the use of sensitive SCRs provides the triggering function at low voltage and low current levels. Furthermore, the trigger switch of the present invention is a simple, economical, and easily constructed circuit which replaces previously designed trigger circuits which comprise a multiplicity of elements and which are more costly to fabricate and assemble.

BRIEF DESCRIPTION OF THE DRAWINGS

For a more complete understanding of the present invention and the advantages thereof, reference is now made to the following Description of the Preferred Embodiments taken in conjunction with the accompanying Drawings, in which:

FIGURE 1 is a schematic diagram of two silicon controlled rectifiers connected in inverse parallel relationship to form the electronic trigger switch of the present invention;

FIGURE 2 is a voltage-current characteristic curve of the trigger switch of FIGURE 1; and

FIGURE 3 is a schematic diagram of the trigger switch of FIGURE 1 used as a trigger for a TRIAC.

DESCRIPTION OF THE PREFERRED EMBODIMENTS

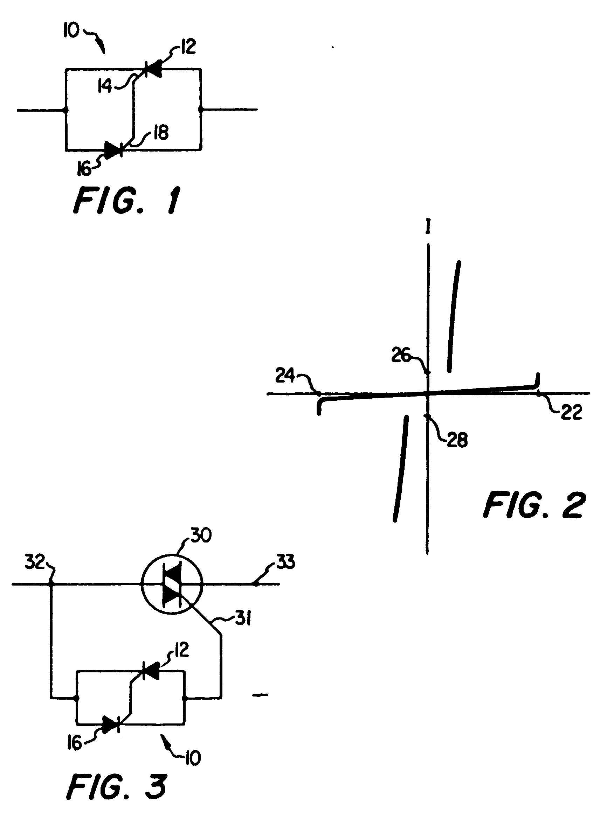

Referring to FIGURE 1, an embodiment of the electronic trigger switch 10 of the present invention is illustrated schematically in a circuit diagram. Trigger switch 10 comprises sensitive silicon controlled rectifier (SCR) 12 and sensitive SCR 16. Sensitive SCRs, such as the EC103 series of SCRs manufactured by Teccor Electronics, Inc., have very high gate impedance but require very low gate current, on the order of 12 to 500 microamperes, to trigger the SCRs to the conductive on-state. Trigger switch 10 is constructed by connecting the anode of SCR 12 to the cathode of SCR 16 and the anode of SCR 16 to the cathode of SCR 12. To complete the connection, the gate electrode 14 of SCR 12 is connected directly to the gate electrode 18 of SCR 16. The resulting circuit produces trigger switch 10, which is a two-terminal, bidirectional device.

The voltage-current response curve of trigger switch 10 is illustrated in FIGURE 2. The connection of identical SCRs in the inverse parallel configuration of FIGURE 1 produces the symmetrical, bilateral response curve shown in FIGURE 2. When voltage is applied to the terminals of trigger switch 10, current is initially blocked because the forward-biased SCR is in the off-state and the other SCR is reverse-biased. As the voltage increases, the voltage reaches the peak inverse voltage (PIV) of the reverse-biased SCR and current begins to flow out from the gate of the reverse-biased SCR. The current flowing out of the gate of the reverse-biased SCR enters the gate of the forward-biased SCR and switches the forward-biased SCR to the on-state, allowing principal current to flow through the forward-biased SCR and thus through trigger switch 10. The voltage-current curve of FIGURE 2 shows the bidirectional behavior of trigger switch 10 by illustrating the symmetrical response as trigger switch 10 is biased in opposite directions. It can be seen that the PIV of the reverse-biased SCR corresponds to the breakover voltage 22, 24 of the trigger switch 10. Once the forward biased SCR is switched to the on-state, the trigger switch 10 will remain in the conductive state as long as the principal current exceeds the minimum holding current 26, 28 of the forward-biased SCR.

An important application for trigger switch 10 is illustrated by the schematic diagram of FIGURE 3. Trigger switch 10 is shown connected to the gate 31 of TRIAC 30 to act as a trigger for TRIAC 30. A TRIAC, such as logic TRIAC L201E7 manufactured by Teccor Electronics, Inc., is a power control device which requires a gate trigger current of about 3 to 25 milliamperes of either polarity to switch the TRIAC to the on-state. The use of trigger switch 10 in conjunction with TRIAC 30, as shown in FIGURE 3, produces a circuit, having terminals 32 and 33, that has the characteristics of a low switching current, a high holding current, and a specific low voltage breakover point of either polarity.

From the foregoing description it can be seen that the present invention provides advantages related to its simplicity of structure and cost savings associated with the reduction of elements and assembly steps.

## Claims

1. A low voltage bidirectional trigger switch (10) for actuating a TRIAC (30) having a TRIAC gate terminal (31) and first and second main terminals (32, 33), comprising:

   a first silicon controlled rectifier (12) having gate, cathode and anode terminals;

   a second silicon controlled rectifier (16) having gate, cathode and anode terminals;

   said first and second silicon controlled rectifiers being in antiparallel connection such that the anode of the first silicon controlled rectifier (12) is connected to the TRIAC gate terminal (31) and the cathode of the first silicon controlled rectifier (12) is connected to the first main terminal (32), and the anode of the second silicon controlled rectifier (16) is connected to the first main terminal (32) and the cathode of the second silicon controlled rectifier (16) is connected to the TRIAC gate terminal (31);

   said gate of the first silicon controlled rectifier (12) being connected directly by an unswitched line to the gate of the second silicon controlled rectifier (16).

2. A power control circuit comprising a low voltage bidirectional trigger switch according to claim 1, **characterized** by:

   said first and second silicon controlled rectifiers (12,16) having substantially identical electrical characteristics, and having substantially identical peak inverse voltages when reverse-biased; and

   said TRIAC (30) being switched on by a low current, low voltage signal applied to the first or second main terminal in excess of the peak inverse voltage.

## Revendications

1. Commutateur de déclenchement électronique bidirectionnel à basse tension (10) pour actionner un thyristor triode bidirectionnel (30) qui a une borne de gâchette (31) de thyristor triode bi-directionnel et une première et une seconde borne principales (32, 33), comprenant :

   un premier redresseur asservi au silicium (12) ayant des bornes de gâchette, de cathode et d'anode ;

   un second redresseur asservi au silicium (16) ayant des bornes de gâchette, de cathode et d'anode ;

   les premier et second redresseurs asservis au silicium mentionnés étant en montage antiparallèle si bien que l'anode du premier redresseur asservi au silicium (12) est reliée à la borne de gâchette de thyristor triode bidirectionnel (31) et la cathode du premier redresseur asservi au silicium (12) est reliée à la première borne principale (32) et l'anode du second redresseur asservi au silicium (16) est reliée à la première borne principale (32) et la cathode du second redresseur asservi au silicium (16) est reliée à la borne de gâchette de thyristor triode bidirectionnel (31),

   ladite gâchette du premier redresseur asservi au silicium (12) étant reliée directement par une ligne non commutée à la gâchette du second redresseur asservi au silicium (16).

2. Circuit de commande de puissance comprenant un commutateur de déclenchement bidirectionnel à basse tension conformément à la revendication 1, caractérisé par :

   les premier et second redresseurs asservis au silicium (12, 16) ayant des caractéristiques électriques substantiellement identiques et ayant des tensions de crête inverses substantiellement identiques lorsqu'ils sont de polarisation inverse et

   ledit thyristor triode bi-directionnel (30) étant mis sous tension par un signal basse tension à courant faible appliqué à la première ou à la seconde borne principale en surplus de la tension de crête inverse.

## Patentansprüche

1. Bidirektionaler Niederspannungs-Triggerschalter (10) zur Betätigung eines TRIAC (30) mit einem TRIAC-Gateanschluß (31) und ersten und zweiten Hauptanschlüssen (32, 33), mit:

   einem ersten Halbleiter-Gleichrichter (12) mit Gate-, Kathoden- und Anodenanschlüssen;

   einem zweiten Halbleiter-Gleichrichter (16), der Gate-, Kathoden- und Anodenanschlüsse aufweist;

   wobei die ersten und zweiten Halbleiter-Gleichrichter derart antiparallel geschaltet sind, daß die Anode des ersten Halbleiter-Gleichrichters (12) an den TRIAC-Gateanschluß (31) und die Kathode des ersten Halbleiter-Gleichrichters (12) an den ersten Hauptanschluß (32), und die Anode des zweiten Halbleiter-Gleichrichters (16) an den ersten Hauptanschluß (32) angeschlossen ist, und die Kathode des zweiten Halbleiter-Gleichrichters (16) mit dem TRIAC-Gateanschluß (31) verbunden ist;

wobei das Gate des ersten Halbleiter-Gleichrichters (12) unmittelbar durch eine schalterfreie Leitung an das Gate des zweiten Halbleiter-Gleichrichters (16) angeschlossen ist.

2. Leistungssteuerschaltung mit einem bidirektionalen Niederspannungs-Triggerschalter nach Anspruch 1, **dadurch gekennzeichnet**,

daß der erste und zweite Halbleiter-Gleichrichter (12, 16) im wesentlichen identische elektrische Eigenschaften haben und beim Anlegen einer Rückwärtsspannung im wesentlichen identische inverse Spitzenspannungen besitzen; und

daß der TRIAC (30) durch ein Signal von kleinem Strom und kleiner Spannung durchgesteuert wird, das über die inverse Spitzenspannung hinaus an den ersten oder zweiten Hauptanschluß gelegt wird.

**FIG. 1**

**FIG. 2**

**FIG. 3**